# EUROPEAN PATENT APPLICATION

(11) **EP 2 408 284 A1**
(43) Date of publication of application: **18.01.2012**
(21) Application number: 10169557.5
(22) Date of filing: 14.07.2010
(51) Int. Cl.: H05K 3/34, H05K 1/11

(54) **Assembly, and associated method, for forming a solder connection**

(71) Applicant: Research In Motion Limited, Waterloo, ON N2L 3W8 (CA)
(72) Inventor: Li, Fan, Waterloo Ontario N2L 3X2 (CA); Duong, Anthony, Waterloo Ontario N2L 3X2 (CA); Henderson, William, Waterloo Ontario N2L 3X2 (CA)
(74) Representative: Fennell, Gareth Charles

(57) **Abstract**

An assembly, and an associated method, facilitates egress of gasses generated during a solder process, thereby reducing the occurrence of voids in the resultant solder connection. A non-conductive channel (36) is formed to extend part way through a solder pad (38). The channel defines a path by which to facilitate the egress of the gas generated during the solder operation.

## Description

The present disclosure relates generally to a manner by which to form a solder connection of a component with a substrate, such as a printed circuit board. More particularly, the present disclosure relates to an assembly, and an associated method, having a solder pad and having a non-conductive channel that extends partway through the pad.

The use of the non-conductive channel, which extends only part way through the solder pad, provides a pathway for the egress of gases that are generated during a solder melt process. By providing the pathway for the egress of the gases, voids that reduce the mechanical strength of the solder connection and reduce the thermal conductivity of the solder connection are less likely to occur.

### Background

Assembly of electronic devices oftentimes makes use of surface mount, through-hole, or other technology by which electrically and structurally to interconnect components parts of the electronic devices. The use of these technologies advantageously facilitates assembly pursuant to an automated procedure in which large numbers of the electrical devices are assembled in an assembly line-like process.

In both a surface-mount and a through-hole solder technique, components are affixed at a substrate by solder connections that affix and electrically connect the components at the substrate. Once the solder connections are formed, the components are interconnected by way of conductive pads and lines disposed at the substrate, thereby to create an operable, electronic circuit.

When, e.g., surface mount technology is utilized, a printed circuit board is prepared, which has solder pads formed thereon. The solder pads are formed, e.g., by an etching process using a film during the printed circuit board fabrication. And, solder paste is applied to the solder pads, such as with a stencil used during a screen printing process. Components, which are to be soldered to the circuit boards, are then seated upon the solder pads of the printed circuit board.

Once the components are seated upon the solder pads at which the solder paste is applied, the circuit board is conveyed to a soldering oven at which the temperature of the printed circuit board, components, and solder paste, is raised. The temperature is raised high enough so that the solder particles of the solder paste melt, thereby to bond the circuit components to the respective solder pads on the circuit board when the solder re-solidifies. Thereby, the components become electrically connected and affixed in position by the formation of the solder joint connections between the components and the substrate formed of the printed circuit board.

When the temperatures are elevated in the reflow soldering oven, or otherwise during formation of the solder connections in which the soldering material is melted, gases are formed as a byproduct of the melting of the solder paste. If the gas that is formed as a byproduct of the solder process does not escape the solder joint prior to its resolidification, a void forms at the solder joint. A void sometimes is large enough to be seen visually, appearing as a small hole that penetrates the surface of the solder joint. The formation of the gases during the melting of the solder is sometimes referred to as out gassing, which results in the formation of voids when the gases do not escape the solder joint prior to re-solidification of the solder material.

Voids in a solder joint are disadvantageous both for the reason that their presence in the solder joint reduces the mechanical strength of the bond of the component with the printed circuit board and also for the reason that the thermal conductivity of the solder connection is reduced, lessening the rate at which heat energy can be dissipated during subsequent operation of the electrical device.

Efforts are therefore made to reduce the occurrence of the voids in the solder joints. A conventional effort makes use of thru channels. Thru channels are formed to extend entirely through solder pads. While the thru channels are effective in the reduction in the formation of voids, the through channels also reduce the joint surface area of the joint between the component and the printed circuit board. This reduction in the joint surface area reduces the strength of the joint as well as reducing electrical contact and reducing the thermal conductivity capabilities of the joint.

Existing efforts by which to reduce the formation of voids in solder connections are generally not wholly beneficial. And, an improved solution would be advantageous.

It is in light of this background information related to solder techniques that the significant improvements of the present invention have evolved.

### Brief Description of the Drawings

Figure 1 illustrates a representation a portion of a substrate upon which an embodiment of the present disclosure is formed.

Figure 2 illustrates a representation, similar to that shown in Figure 1, but of a portion of another printed circuit board forming a substrate of another exemplary implementation of an embodiment of the present disclosure.

Figure 3 illustrates a representation of a component seated upon a substrate formed upon a printed circuit board, such as the printed circuit board shown in Figures 1 or 2, and upon which a component is seated and soldered thereupon.

Figure 4 illustrates a representation, taken from the beneath a component, which includes a portion of an embodiment of the present disclosure formed thereon.

Figure 5 illustrates a process diagram representative of the process of operation of an embodiment of the present disclosure.

### Detailed Description

The present disclosure, accordingly, advantageously provides an assembly, and an associated methodology, by which to form a solder connection of a component with a substrate, such as a printed circuit board.

Through operation of an embodiment of the present disclosure, a manner is provided that facilitates formation of a solder connection and includes use of a solder mask pattern that defines a pad and that defines a non-conductive channel that extends part way through the pad.

In one aspect of the present disclosure, the use of the non-conductive channel, which extends only part way through the pad, reduces the occurrence of out gassing and resultant formation of voids, which reduce the strength of thermal conductivity of the joint.

In another aspect of the present disclosure, a solder pad is formed upon a printed circuit board, or other substrate. The solder pad is formed of a conductive material, such as copper-based material, and is of dimensions to permit seating of a component thereon. A channel is formed to extend part way, but not completely, through the solder pad. The channel is formed, for instance, by a solder mask during formation of the solder pad or subsequent to formation of the solder pad by etching, or otherwise removing, the conductive material of the solder pad to form the channel.

In another aspect of the present disclosure, the solder pad and the channel are both defined upon the substrate. The channel, formed upon the same surface as the solder pad, is created, in one implementation, by the solder mask and, in another implementation, by an etching process or otherwise removing conductive material, to define the channel. The channel extends only part way through, e.g., half way through, the solder pad. The channel, so-formed, facilitates reduction in formation of voids during a solder process, by providing a path for gasses generated as a byproduct of the solder process to escape from the solder weld. But, because the channel does not extend entirely through the solder pad, the reduced mechanical strength and reduced thermal conductivity of solder connections exhibited by conventional solder connections that are formed making use of conventional thru channels that extend completely through a solder pad.

In another aspect of the present disclosure, the solder pad and channel are defined upon different substrates. That is to say, the solder pad is defined upon a first substrate, e.g., the printed circuit board, and the channel is defined upon a second substrate, e.g., a surface of a component that seats upon the solder pad. The channel, formed upon the second substrate is, in one implementation, formed pursuant to an etching process.

In another aspect of the present disclosure, the channel is configured to be of dimensions to facilitate escape of gases generated as a byproduct of the reflow, or other, solder process. The channel is configured to be of a length to extend only partially along a dimension of the solder pad. The channel facilitates breaking through the surface tension on a boundary of a bubble of gas and then providing a pathway for out gasses to escape. The escaped gas does not remain at the solder connection, and resultant voids do not form.

In another aspect of the present disclosure, a reflow, or through hole, solder process includes applying a solder mask on a printed circuit board, or other substrate. The solder mask provides for formation of a mask pattern on the substrate. When solder paste is subsequently applied to the substrate at areas defined by the solder mask and a component is seated upon the solder pad, the channel provides a passage way to permit the egress of byproduct gases that form pursuant to heating of the solder paste in which a solder connection is formed between the solder pad and the component.

In another aspect of the present disclosure, a reflow, or thru hole, technique includes application of a solder mask on a printed circuit board, or other substrate, and upon a seating surface of a component, forming a second substrate. The solder mask provides for the formation of a mask pattern on the first substrate. The mask pattern formed upon the first substrate, the printed circuit board, provides for formation of a solder pad. And, the second substrate provides a conductive part for seating upon the solder pad and a non-conductive channel that, when the component is seated upon the solder pad, the channel extends part way across the solder pad. When solder paste is subsequently applied to the first substrate and the component is seated upon the solder pad, the channel forms a passage way to permit the egress of gasses that forms pursuant to heating of the solder paste, and a solder connection is formed between the solder pad and the component.

In these and other aspects, therefore, an assembly, and an associated method, facilitates solder connection of a component to a substrate. A conductive part is disposed upon the substrate. The conductive part defines a pad formed of at least a portion of the conductive part, and the conductive part has a first side edge and a second side edge. At least a first non-conductive channel is positionable at the first side edge of the, and extending part way through, the pad. The non-conductive channel is of dimensions configured to facilitate reduction in formation of voids during solder application at the pad to affix the component to the solder pad.

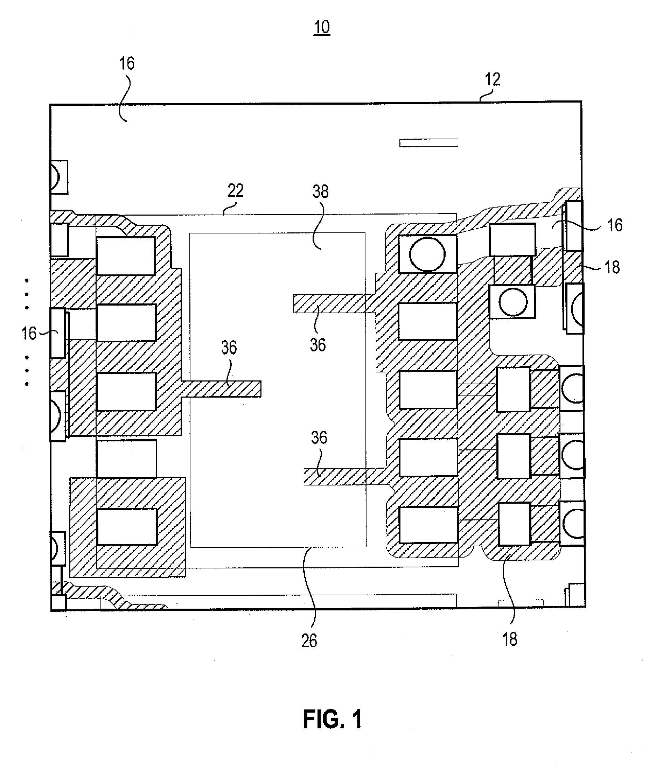

Turning first to Figure 1, a representation 10, which includes a portion of a printed circuit board 12, forming a substrate, is shown. The printed circuit board is of dimensions permitting placement of a plurality of components (not shown in Figure 1) thereon. In the exemplary implementation shown in Figure 1, the printed circuit board is constructed to be utilized with a Surface Mount Technology (SMT) technique in which components are seated upon one, or both, face surfaces of the printed circuit board and connected to the printed circuit board by solder connections formed, such as during a reflow solder operation. While the printed circuit board 12 shall be described with respect to its exemplary implementation, it should be understood that the description is analogously applicable to a circuit board or other substrate constructed in another manner. And, while the plan view of the printed circuit board shows a single side surface of the printed circuit board, in a typical implementation, components are mountable upon both sides of the circuit board. The plan view is representative of either surface of the circuit board.

The portion of the printed circuit board 12 shown in Figure 1 is fabricated to include a conductive material, such as a copper-based material, to define a conductive portion 16 and includes a portion 18 that is non-conductive. A solder mask pattern is utilized by which to form a solder pad at the conductive portion 16. The solder mask pattern is carefully selected and used so that when components are seated thereon, appropriate portions of the component engage electrically with the substrate and other portions of the components are electrically isolated from the substrate.

The square 22, is representative of the outline of an exemplary component, and the rectangle 26, is representative of a ground pad of the component. Review of the relationship between the exemplary component and the printed circuit board and solder mask pattern defining the conductive and non-conductive portions 16 and 18 thereon show that a conductive pad 38 defined upon the surface of the printed circuit board align with non-ground portions of the seating surface of the component, when placed thereon.

The surface configuration further includes channels 36 forming part of an embodiment of the present disclosure. The channels 36 extend part way, but not all the way, through a solder pad 38 that is formed on the printed circuit board 12. In one implementation, the channel extends substantially halfway through the solder pad. And, in the exemplary implementation, shown in Figure 1, three channels extend partially through the solder pad, in longitudinal directions substantially transverse to the solder pad. The channels extend part way through the solder pad, starting at edge sides of the solder pad. And, in the illustrated implementation of Figure 1, the channels extend from the edge of the conductive portion 16 at which the solder pad is defined.

During a solder reflow, or other, operation in which solder paste is heated to melt the solder and form a solder connection, the channels 36 facilitate egress of gasses generated during the solder process, thereby reducing the occurrence of voids caused by out gassing. The channels 36 help to break through the surface tension on the boundary of a gaseous bubble and then allow the out gasses to escape.

The channels, just extend from an edge of a conductive portion at which the solder pads are defined partway through the associated solder pad. When the solder pad is smaller than the conductive portion, the channel extends from beyond the solder pad, that is, the edge of the conductive portion at which the solder pad is defined. Thereby, gas generated during the solder process is vented out of the solder pad and associated conductive portion area.

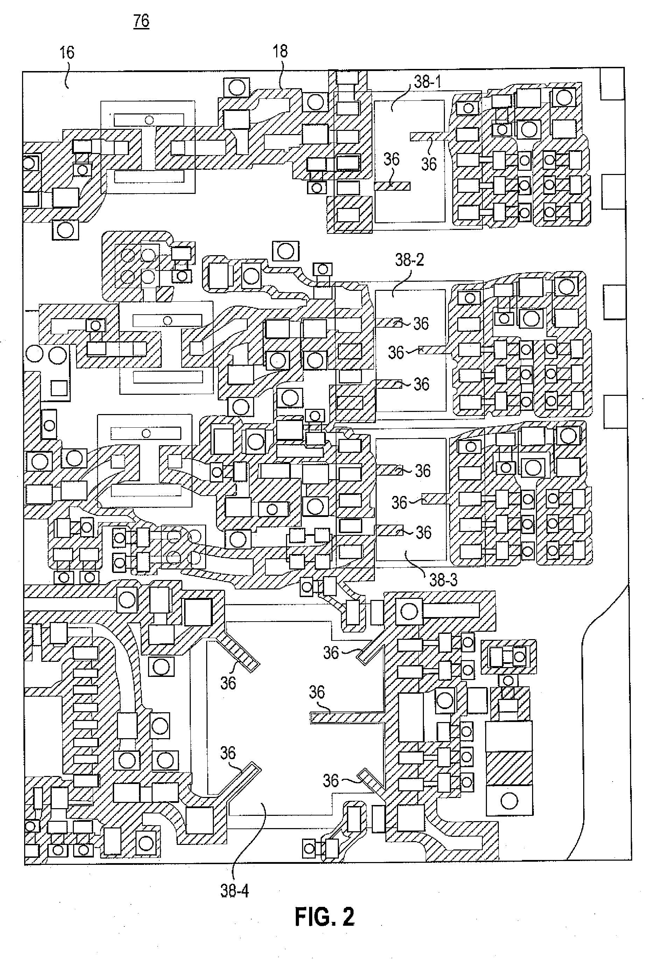

Figure 2 illustrates another exemplary representation 76 of a portion of a printed circuit board of an alternate configuration. Again, the substrate includes conductive and non-conductive portions 16 and 18. The conductive portions again define solder pads. In this illustration, a plurality of solder pads 38 is represented. Solder pads 38-1, 38-2, and 38-3 have channels 36 extending transversely from side edges of the conductive portions that define the respective solder pads, similar to the implementation shown in Figure 1. Channels 36 at the solder pad 38-4, in contrast, extend part way through the solder pads from the corners of the solder pad. And, an additional channel extends transversely part way through the solder pad, similar to the channels 36 defmed at the solder pads 38-1 through 38-3. Analogous to the channels 36 of the implementation shown in Figure 1, the channels function to facilitate egress of gasses generated during the solder process to the reduce the formation of voids at the solder connection between a component and the solder pad on the printed circuit board substrate.

In one implementation, the channels 38 are defined during circuit board fabrication in which the conductive portion, used pursuant to application of the conductive material to the substrate formed of the printed solder pads defined thereat, and the channels 38 are circuit board in which the solder mask pattern defines which portions of the substrate are formed by etching with a photographic film.

Subsequent to formation of the printed circuit board with the conductive and non-conductive portions, solder material is applied to the circuit board, and components that are to be mounted at the solder pads are placed in position at the appropriate solder pads. Reflow, or other, solder operations are performed to melt the solder material and to affix and electrically connect the components to the conductive portions of the substrate.

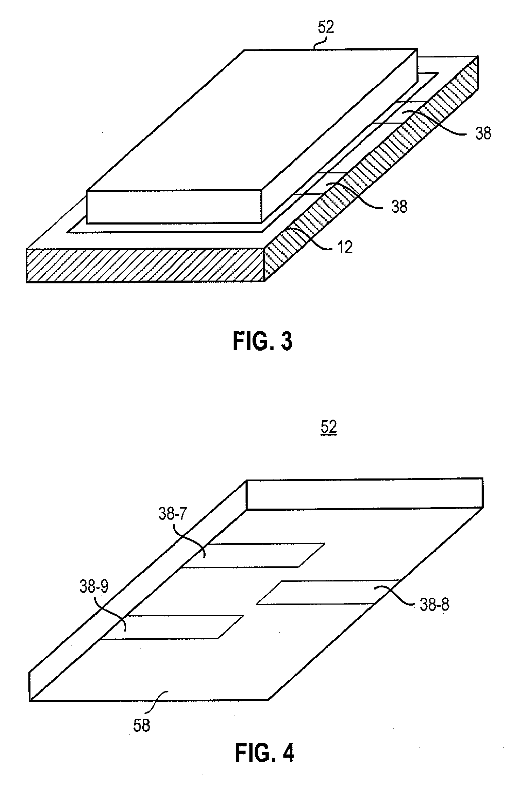

Figure 3 again illustrates a portion of the printed circuit board 12, here showing positioning of a component 52 thereon. Through use of the channels that extend from an edge of a conductive portion to partway through the solder pad 36 upon which the component 52 is positioned, gases generated during a solder melt operation are channeled by the channels 38 (shown in Figures 1-2) and are less likely to be trapped and form voids in the resultant solder connection. And, because the channels extend only part way, and not all of the way, through the solder pad, the solder connection is stronger than that permitted by a solder connection formed upon a solder pad in which channels extending entirely through the solder pad are used.

Figure 4 illustrates a component 52 utilized pursuant to an alternate implementation of an embodiment of the present disclosure. In this implementation, a bottom face surface 58 of the component comprises the channels 38. Here, three channels, channels 38-7, 38-8, and 38-9 are formed upon the bottom face surface. These channels are used alternate to, or in addition to, the channels formed on the printed circuit board.

The channels 38 formed on the face surface of the component 52 are formed in manners analogous to the manners by which the channels 38 on the circuit board 12 are formed. In one implementation, the channels are formed by an etching process with a photographic film during a fabrication process to cause portions of the surface 58 to contain conductive material and to define portions that do not contain the conductive material and, here, form the channels 38. Or, alternately, the channels are formed by etching away, or otherwise removing, conductive material to form the channels 38. Here, again, the channels function to facilitate egress of gases formed during a solder melt process to reduce the occurrence of voids. Because the channels extend only part way through the solder pad upon which the component is positioned, the strength of the solder connection is greater than if the channels were to extend fully through the solder pad upon which the component is mounted.

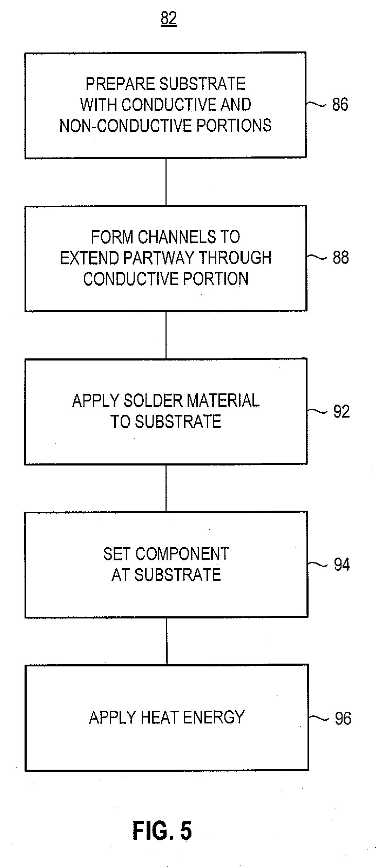

Figure 5 illustrates a process diagram 82 representative of the process of operation of an embodiment of the present disclosure. First, and as indicated by the block 86, a substrate is prepared to include both conductive and non-conductive portions. The conductive portions include a solder pad of dimensions permitting seating of a component thereon. And, as indicated by the block 88, one or more channels are formed to extend from an edge of a conductive portion to part way through, but not all of the way through, the solder pad. The channel is formed, in one implementation, on the same substrate as that upon which the solder pad is formed or is formed on a surface of the component that is to be seated upon the solder pad.

Then, and as indicated by the block 92, a solder material is applied to the substrate. Then, and as indicated by the block 94, a component is seated upon the solder pad. Then, and as indicated by the block 96, heat energy is applied to melt the solder material, such as heat energy applied during a reflow solder process.

Because the channels that are utilized to facilitate egress of gases generated during the solder process are utilized, voids formed as a result of out gassing are less likely to occur. Additionally, because the channels extend only part way through the solder pad, the strength of the resultant solder connection is improved relative to conventional techniques.

Presently preferred embodiments of the disclosure and many of its improvements and advantages have been described with a degree of particularity. The description is of preferred examples of implementing the disclosure and the description of preferred examples is not necessarily intended to limit the scope of the disclosure. The scope of the disclosure is defined by the following claims.

## Claims

1. An assembly (110) for facilitating solder connection of a component (52) to a substrate (12), said assembly comprising:
a conductive part (38) disposed upon the substrate (12) and defining a pad (38) formed of at least a portion of, said conductive part, said conductive part having a first side edge and a second side edge;
at least a first non-conductive channel (36) positionable at the first side edge of said conductive part (38) and positionable to extend partway through said pad (38), said non-conductive channel of dimensions configured to facilitate reduction in formation of voids during solder application at the pad to affix the component thereat.

2. The assembly (10) of claim 1 wherein said conductive part (38) comprises a first conductive part (38-1) and at least a second conductive part (38-2), defining respectively a first pad and at least a second pad, the first pad and the at least second pad arranged in a pad array.

3. The assembly (10) of claim 1 further comprising at least a second non-conductive channel (36), the second non-conductive channel positionable at the second side edge of said conductive part (38) and extending partway through said pad, said second non-conductive channel (36) of dimensions configured to facilitate reduction in the formation of voids during solder application at the thermal pad to affix the component thereat.

4. The assembly (10) of claim 3 wherein said second non-conductive channel (36) is formed at the substrate (12).

5. The assembly (10) of claim 3 wherein said second non-conductive channel (36) is formed at the component (52).

6. The assembly (10) of claim 3 wherein said at least second non-conductive channel (36) comprises a plurality of non-conductive channels, with at least one non-conductive channel (36) formed at the substrate (12) and at least one non-conductive channel (36) formed at the component (52).

7. The assembly (10) of claim 1 wherein said first non-conductive channel (36) is formed at the substrate (12).

8. The assembly (10) of claim 1 wherein said first non-conductive channel (36) is formed at the component (52).

9. The assembly (10) of claim 1 wherein said at least first non-conductive channel (36) comprises a plurality of non-conductive channels, with at least one non-conductive channel formed at the substrate (12) and at least one non-conductive channel formed at the component (52).

10. The assembly (10) of claim 1 wherein said pad defined at said conductive part is of a solder mask pattern defined dimension.

11. The assembly (10) of claim 1 wherein said first non-conductive channel (36) extends substantially halfway through said pad (38).

12. A method (82) for facilitating solder connection of a component to a substrate, said method comprising:
disposing (86) a conductive part upon the substrate, the conductive part comprising a first side edge and a second side edge;
defining (86) a pad formed of at least a portion of the conductive part disposed during said disposing; and
positioning (88) a first non-conductive channel at the first side edge of the conductive part and extending partway through the pad, the first non-conductive channel of dimensions configured to facilitate reduction in formation of voids during solder application at the pad to affix the component thereat.

13. The method (82) of claim 12 wherein said positioning (88) the first non-conductive channel comprises forming the first non-conductive channel on the substrate.

14. The method (82) of claim 12 wherein said positioning (88) the first non-conductive material comprises forming the first non-conductive channel on the component.

15. The method (82) of claim 14 wherein said positioning (88) the first non-conductive channel comprises forming the first non-conductive channel at the substrate and wherein said positioning the second non-conductive channel comprises forming the second non-conductive channel comprises forming the second non-conductive channel at the component.

## Amended claims

### Amended claims in accordance with Rule 137(2) EPC.

**1.** An assembly (10) for facilitating solder connection of a component (52) to a substrate (12), said assembly comprising:
a conductive material (16) disposed upon the substrate (12) and having a pad portion (38) formed of at least a portion of, said conductive material and upon which pad portion the component is to be soldered, said pad portion defined by a first side edge and a second side edge;
said pad portion further defined by a channel (36) wherein said pad portion is absent said conductive material, said channel extending from said first side edge of said pad portion toward said second side edge partway through, but less than completely through, said pad portion, whereby solder void formation is reduced and the strength of the solder joint between the component and said conductive material is maintained.

**2.** The assembly of claim 1 wherein said conductive material comprises a first pad portion (38-1) and at least a second pad portion (38-2), defining respectively a first pad portion and at least a second pad portion, the first pad portion and the at least second pad portion arranged in a pad array.

**3.** The assembly of claim 1 further comprising at least a second non-conductive channel (36), said second non-conductive channel extending from said second side edge of said pad portion toward said first side edge and extending partway through, but less than completely through, said pad portion.

**4.** The assembly of claim 1 wherein said component further comprises at least a second non-conductive channel extending from said second side edge of said pad portion toward said first side edge and extending partway through, but less than completely through to said first edge, whereby solder void formation is reduced and the strength of the solder joint between the component and said conductive material is maintained.

**5.** The assembly of claim 3 wherein said at least second non-conductive channel (36) comprises a plurality of non-conductive channels, with at least one non-conductive channel (36) formed at the substrate (12) and at least one non-conductive channel (36) formed at the component (52).

**6.** The assembly of claim 1 wherein said pad portion is defined by a solder mask pattern for said conductive material.

**7.** The assembly of claim 1 wherein said channel (36) extends substantially halfway through said pad (38).

**8.** A method (82) for facilitating solder connection of a component to a substrate, said method comprising:
disposing (86) a conductive material upon the substrate
defining (86) a pad portion (38), formed of at least a portion of the conductive material disposed during said disposing, to have a first side edge and a second side edge and a channel (36) absent said conductive material, said channel extending from said first side edge of said pad portion toward said second side edge and partway through, but less than completely through, said pad portion, whereby solder void formation is reduced and the strength of the solder joint between the component and said conductive material is maintained.

**9.** The method (82) of claim 8 further comprises disposing a second non-conductive channel at said pad portion, said second channel extending from said second side edge of said pad portion toward said first side edge and partway through, but less than completely through, said pad portion.

**10.** The method (82) of claim 8 further comprises disposing a second non-conductive channel at said component, extending from one of said first side edge and said second side edge of said pad portion toward the other of said first side edge and said second side and partway through, but less than completely through, to said other of said first side edge and said second side.

**11.** The method (82) of claim 10 wherein said disposing said second non-conductive channel comprises disposing said second non-conductive channel to extend from said second side edge of said pad portion toward said first side edge.
